# EUROPÄISCHE PATENTSCHRIFT

(11) **EP 4 629 756 B1**
(45) Veröffentlichungstag und Bekanntmachung des Hinweises auf die Patenterteilung: **12.08.2026**
(21) Anmeldenummer: 24168084.2
(22) Anmeldetag: 02.04.2024
(51) Int. Cl.: H05K 1/189, H05K 3/321, H05K 1/03, B32B 7/12, H10W 70/60, H10W 70/67, H10W 72/00

(54) **ELEKTRONISCHES SYSTEM UND VERFAHREN ZUR HERSTELLUNG DES ELEKTRONISCHEN SYSTEMS**
ELECTRONIC SYSTEM AND METHOD FOR MANUFACTURING OF THE ELECTRONIC SYSTEM
SYSTÈME ÉLECTRONIQUE ET PROCÉDÉ POUR LA PRODUCTION DU SYSTÈME ÉLECTRONIQUE

(43) Veröffentlichungstag der Anmeldung: 08.10.2025
(73) Patentinhaber: Lohmann GmbH & Co. KG, 56567 Neuwied (DE)
(72) Erfinder: Volker, Lutz, 56579 Rengsdorf (DE); Weisenstein, Christian, 57548 Kirchen (DE); Reukauf, Phil-Dominik, 56584 Meinborn (DE); Krämer, Christoph, 56567 Neuwied (DE)

(56) Entgegenhaltungen:
- WO-A1-86/06573
- DE-C1- 10 140 661
- US-A1- 2007 116 961
- US-A1- 2017 170 152
- US-A1- 2018 182 944
- US-A1- 2019 103 532
- US-A1- 2022 025 229
- US-A1- 2022 102 326

## Beschreibung

Die Erfindung betrifft ein elektronisches System und ein Verfahren zur industriellen Herstellung des elektronischen Systems.

Anisotrop elektrisch leitfähige Klebefilme sind beispielsweise aus der US 2007/0116961 A1 bekannt und werden üblicherweise verwendet, um zwei Substrate mit Leiterbahnen zur Herstellung eines Laminats miteinander zu verbinden, wobei durch den anisotrop elektrisch leitfähigen Klebefilm die einzelnen Leiterbahnen miteinander verbunden werden können, ohne dass es zu Kurzschlüssen kommt.

Ferner ist aus dem Stand der Technik bekannt, zur Bestückung von Leiterplatten mit einer Mehrzahl von elektronischen Komponenten, beispielsweise oberflächenmontierte Bauelemente, für jede elektronische Komponente einzeln einen elektrisch leitfähigen Flüssigklebstoff auf der Leiterplatte aufzutragen und anschließend mittels eines Pick-and-Place Automaten die elektronischen Komponenten an den noch flüssigen Klebstoff anzudrücken. Üblicherweise wird die Leiterplatte zum Schluss durch eine Beheizungsanlage, beispielsweise einen Reflow-Ofen, geführt, in welcher der Flüssigklebstoff ausgehärtet wird. Ein solches Verfahren ist beispielsweise in der DE 101 40 661 C1 offenbart. Alternativ lassen sich diese Pick-and-Place Verfahren auch mit Lötpasten oder Lötzinn anstelle des Flüssigklebstoffs ausführen.

US 2018/0182944 A1 offenbart ein Verfahren zur Befestigung einer Mehrzahl von elektronischen Komponenten auf einer flexiblen Leiterplatte. Hierbei werden in einem Druckprozess Klebeflächen aus einem leitfähigen Klebstoff unter jede einzelne Komponente platziert.

US 2022/0025229 A1 offenbart einen latent reaktiven, leitfähigen Klebefilm auf Polyurethan-Basis. Der Klebefilm kombiniert eine elektrische Leitfähigkeit mit einer starken Haftung nach seiner Vernetzung und ist speziell für Anwendungen in der Teppich- und Textilverklebung konzipiert, da Klebstoffe in diesen stark mechanisch beansprucht werden.

US 2022/0102326 A1 offenbart einen leitfähigen Klebefilm insbesondere zur Verklebung von LED-Displays. Der Klebefilm kann auf Epoxid-Harzen oder AcrylatHarzen basieren, die mit Hitze oder UV-Bestrahlung vernetzbar sein können.

US 2019/0103532 A1 offenbart einen leitfähigen Klebefilm, der in der Herstellung von LED-Chips zum Einsatz kommt. Der Klebefilm weist ein hitzevernetzbares Harz auf und wird in der Herstellung der LED-Chips durch einen Heißpressvorgang vernetzt. US 2017/0170152 A1 offenbart ein Display-Gerät, in welchem LEDs über einen leitfähigen Klebefilm mit einer Elektrode elektrisch kontaktiert sind.

Es gibt mehr und mehr Anwendungen, in denen eine große Anzahl elektronischer Komponenten auf Leiterplatten anzubringen und zu kontaktieren sind, wie beispielswiese bei der Herstellung von LED-Anzeigen. Das klassische Pick-and-Place Verfahren, in welchem elektronische Komponenten einzeln abgelegt werden, ist für diese Anwendungen sehr aufwändig, da die Komplexität des Verfahrens proportional zur Anzahl der elektronischen Komponenten ist. Entsprechend besteht ein Bedarf nach elektronischen Systemen, in welchen elektronische Komponenten auf eine Weise mit Leiterbahnen eines Substrats kontaktiert werden können, die beliebig skalierbar ist und dabei keine Nachteile bezüglich der Herstellungskosten und der Qualität der Kontaktierung aufweist.

Die Aufgabe der Erfindung besteht insbesondere aber nicht ausschließlich darin, ein elektronisches System beziehungsweise ein Verfahren zur Herstellung des elektronischen Systems bereitzustellen, welche verbesserte Eigenschaften bezüglich einer Fixierung und elektrischen Kontaktierung von elektronischen Komponenten an einem Substrat aufweisen. Die Aufgabe wird erfindungsgemäß durch die Merkmale der Ansprüche 1 und 7 gelöst, während vorteilhafte Ausgestaltungen und Weiterbildungen der Erfindung den Unteransprüchen entnommen werden können.

Hierdurch kann ein elektronisches System mit einer beliebigen Anzahl elektronischer Komponenten bereitgestellt werden, dessen Herstellung die Nachteile des klassischen Pick-and-Place-Verfahren vermeidet. Vorteilhaft kann anstelle einer Mehrzahl von Verfahrensschritten zur Auftragung einzelner Klebepunkte der Klebefilm in einem einzigen Verfahrensschritt vollständig appliziert werden. Besonders vorteilhaft kann die elektronische Komponente in dem unvernetzten oder teilvernetzten Zustand der Klebefilms in den Klebefilm hineingedrückt werden, wodurch eine vollständige Benetzung der elektronischen Komponente und eine robuste Fixierung nach der Vernetzung des Klebefilms gewährleistet werden kann.

Das elektronische System kann eine beliebige Anzahl an Substraten, Klebefilmen und elektronischen Komponenten aufweisen. Im Fall, dass das elektronische System mehrere Substrate und Klebefilme aufweist, könnten die Substrate und Klebefilme zueinander identische oder voneinander verschiedene Maße aufweisen. Ferner könnten die Substrate beispielsweise übereinander angeordnet sein, wobei die Klebefilme sowohl zwischen den Substraten als auch auf zumindest einer äußeren Oberfläche der Substrate angeordnet sind und die elektronische Komponente mit einer auf der äußeren Oberfläche angeordneten Leiterbahn verbinden.

Das Substrat kann beliebige, elektrisch isolierenden Materialien aufweisen. Darunter, dass ein Material "elektrisch isolierend" ist, soll in diesem Zusammenhang verstanden werden, dass das Material bei 25°C einen spezifischen Widerstand von mindestens 10¹¹ Ωmm²/m aufweist. Beispielsweise könnte das Substrat als eine Glasplatte, eine Kunststoffplatte oder eine Zellstoffplatte ausgebildet sein. Das Substrat ist bevorzugt als eine Leiterplatte ausgebildet. Das Substrat kann als eine einlagige Leiterplatte oder als eine mehrlagige Leiterplatte ausgebildet sein. Das Substrat könnte aus einem starren, spröden Material bestehen, wie beispielsweise einem faserverstärkten Kunststoff oder Hartpapier. Bevorzugt besteht das Substrat aus einem flexiblen, duktilen Material, wie beispielsweise einer Folie, wobei die Folie Kunststoffe und/oder Zellstoffe aufweisen kann.

Das Substrat kann eine beliebige Anzahl an Leiterbahnen aufweisen. Bevorzugt weist das Substrat zumindest ein Paar von Leiterbahnen auf, welches eine Energieversorgung der elektronischen Komponente bereitstellt. Die Leiterbahn kann das Substrat teilweise oder vollständig durchdringen. Bevorzugt ist die Leiterbahn als eine Beschichtung der Oberfläche des Substrats ausgebildet. Die Leiterbahn kann mittels beliebiger Beschichtungsverfahren oder Druckverfahren auf die Oberfläche des Substrats aufgetragen sein, wie beispielsweise Rakelbeschichtung, Schlitzdüsenbeschichtung, Vorhangbeschichtung, Tiefdruck, Offsetdruck, Flexodruck, Tintenstrahldruck, Siebdruck, LAM-Druck oder Stereolithographie.

Bevorzugt ist das Substrat zumindest innerhalb einer bestückten Oberfläche frei von Einbuchtungen, Ausbuchtungen und Ausnehmungen. Die "bestückte Oberfläche" soll als eine kleinstmögliche zusammenhängende Teiloberfläche des Substrats verstanden werden, welche in einer Draufsicht auf das elektronische System alle elektronischen Komponenten des elektronischen Systems umfasst. Die Draufsicht ist in diesem Zusammenhang als eine Darstellung des elektronischen Systems von oben oder unten zu verstehen, in der Bauteile des elektronischen Systems, welche die elektronische Komponente abdecken würden, nicht abgebildet sind. Das Substrat könnte außerhalb der bestückten Oberfläche Kanten, Einbuchtungen, Ausbuchtungen und/oder Ausnehmungen aufweisen, welche beispielsweise zur Fixierung des elektronischen Systems ausgelegt sein könnten. Das Substrat kann beliebige Formen aufweisen, welche beliebig gekrümmt sein können. Bevorzugt ist das Substrat schichtförmig. Darunter, dass ein Objekt "schichtförmig" ist, soll verstanden werden, dass das Objekt in einem Ruhezustand keine Krümmungen oder Faltungen aufweist und eine Länge und Breite des Objekts mindestens 500 %, vorteilhaft 750 % und besonders vorteilhaft mindestens 1000 % einer Höhe des Objekts betragen. Unter einem "Ruhezustand" des Objekts soll in diesem Zusammenhang ein Zustand verstanden werden, in welchem das Objekt auf einer flachen Oberfläche aufliegt und keiner Verformung wie beispielsweise einer Biegung, Dehnung oder Faltung ausgesetzt ist.

Bevorzugt wird das Substrat in dem Verfahren mittels einer Substrat-Vorratsrolle bereitgestellt. Es werden bevorzugt eine Vielzahl von Substraten entlang der Produktionslinie transportiert. Besonders bevorzugt sind die Substrate Teil einer Substrat-Bahn, welche auf einen Kern der Substrat-Versorgungsrolle aufgewickelt ist und kontinuierlich abgewickelt wird. Die Substrat-Bahn könnte einen entfernbaren Träger aufweisen, welcher nach dem Applizieren und Vernetzen des Klebefilms entfernt und auf eine weitere Entsorgungsrolle aufgewickelt werden könnte. Alternativ könnte die Substrat-Bahn als eine einzelne Schicht ausgebildet sein, aus der nach dem Applizieren und Vernetzen des Klebefilms einzelne elektronische Systeme herausgeschnitten oder herausgestanzt werden.

Bevorzugt ist der Klebefilm schichtförmig. Der Klebefilm kann in dem Ruhezustand bei einer Draufsicht beliebige Formen annehmen, wie beispielsweise eine dreieckige, rechteckige, oder ovale Form.

Der Klebefilm ist senkrecht zu einer Hauptseite des Klebefilms elektrisch leitfähig und parallel zu der Hauptseite im Wesentlichen elektrisch isolierend ist. Der Klebefilm ist zumindest in einem Maße elektrisch isolierend, dass ein Abstand benachbarter Kontaktflächen parallel zu der Hauptseite des Klebefilms groß genug ist, um einen Kurzschluss zu vermeiden. Ein minimaler Abstand, bei welchem die benachbarten Kontaktflächen noch voneinander elektrisch isoliert sind, wird auch als "Rastermaß" oder "Pitch" bezeichnet. Darunter, dass ein Material "elektrisch leitfähig ist", soll in diesem Zusammenhang verstanden werden, dass das Material oder Element bei 25°C einen spezifischen Widerstand von höchstens 100 Ωmm²/m aufweist.

Der Klebefilm weist zumindest einen elektrisch leitfähigen Klebstoff auf. Der Klebstoff könnte zumindest ein elektrisch leitfähiges Polymer aufweisen. Beispielsweise könnte der Klebstoff ein PEDOT:PSS-basierter Klebstoff sein. Bevorzugt weist der Klebstoff elektrisch leitfähige Partikel auf. Die elektrisch leitfähigen Partikel könnten beispielsweise aus einem Metall, einem leitfähigen Polymer oder Kohlenstoff bestehen, oder als ein metallbeschichteter Körper aus Glas, Kunststoff oder Keramik ausgebildet sein. Besonders bevorzugt weist der Klebefilm im Bereich der Kontaktfläche eine reduzierte Schichtdicke auf, wobei die Kontaktfläche unmittelbar mit den elektrisch leitfähigen Partikeln kontaktiert ist. Dies kann durch das Andrücken der elektronischen Komponente in dem unvernetzten oder teilvernetzten Zustand des Klebefilms erreicht werden, da der Klebefilm, während er haftklebrig ist, eine ausreichende Viskosität aufweist, um während des Andrückens unterhalb der Kontaktfläche zu entweichen.

Die elektrisch leitfähigen Partikel könnten in Form von Ketten, die senkrecht zur Hauptseite des Klebefilms ausgerichtet sind, angeordnet sein. Diese Anordnung der elektrisch leitfähigen Partikel kann beispielsweise durch ein Ausrichten der elektrisch leitfähigen Partikel mittels eines elektromagnetischen Felds erreicht werden. Alternativ könnte der Klebefilm elektrisch leitfähige Partikel aufweisen, deren durchschnittlicher Durchmesser größer als eine Schichtdicke des Klebefilms ist. Bevorzugt sind die elektrisch leitfähigen Partikel in den elektrisch leitfähigen Klebstoff eindispergiert.

Der Klebefilm weist einen Polyurethan-Klebstoff, welcher elektrisch leitfähig ist, auf.

Der Klebefilm kann zusätzlich zu dem elektrisch leitfähigen Klebstoff beliebige weitere Substanzen und Additive aufweisen, wie beispielsweise Alterungsschutzmittel, Füllmittel, thermisch leitfähige Partikel, thermisch isolierende Partikel, Vernetzer, Katalysatoren, Verdickungsmittel und/oder Tackifier.

Der Klebefilm könnte als Teil eines einseitigen oder doppelseitigen Klebebands ausgebildet sein. Das einseitige oder doppelseitiges Klebeband weist zumindest einen anisotrop elektrisch leitfähigen Träger auf. Der Träger könnte zumindest ein elektrisch isolierendes Material, beispielsweise einen Kunststoff oder einen Zellstoff, aufweisen, welches eine Mehrzahl an Ausnehmungen aufweist, die mit elektrisch leitfähigem Material, beispielsweise einem Metall oder Kohlenstoff, gefüllt sind. Im erfindungsgemäßen Verfahren zur industriellen Herstellung des elektronischen Systems ist der Klebefilm als ein Transferfilm ausgebildet. Unter einem "Transferfilm" soll ein Klebefilm verstanden werden, welcher in einem nicht-applizierten Zustand als Teil eines Transferklebebands vorliegt. Das einseitige oder doppelseitige Klebeband oder das Transferklebeband können einen entfernbaren Träger, auch "Release Liner" genannt, aufweisen, der eine äußere Oberfläche des Klebefilms abdeckt. Im Fall, dass das einseitige oder doppelseitige Klebeband oder das Transferklebeband als ein gewickeltes Klebeband vorliegen, können sie nur einen entfernbaren Träger aufweisen, alternativ könnten das einseitige oder doppelseitige Klebeband oder das Transferklebeband als ein ebenes Klebeband, beispielsweise ein Stanzteil, vorliegen und zwei entfernbare Träger aufweisen, welche auf gegenüberliegenden äußeren Seiten des Klebefilms angeordnet sind. Beispielsweise könnte der entfernbare Träger als ein silikonisierter Zellstoff ausgebildet sein.

Darunter, dass der Klebefilm "haftklebrig" ist, soll verstanden werden, dass der Klebefilm ausgelegt ist, durch bloßes Auflegen und/oder durch einen manuellen Druck eine nicht kovalente adhäsive Verbindung zu einem Fügepartner auszubilden.

Bevorzugt weist der Klebefilm in dem unvernetzten oder teilvernetzten Zustand eine Glasübergangstemperatur von höchstens -10°C auf.

Unter einem "unvernetzten oder teilvernetzten Zustand" soll ein Zustand verstanden werden, in welchem die Polymere des Klebefilms untereinander entweder nicht oder nur teilweise vernetzt sind. Der unvernetzte oder teilvernetzte Zustand kann bei vordefinierten Konditionen vorliegen, wie beispielsweise einer bestimmten Temperatur. Der unvernetzte oder teilvernetzte Zustand kann über einen beliebigen Zeitraum aufrechtherhalten werden und unterscheidet sich von temporären Zuständen. Ein temporärer Zustand könnte beispielsweise nur an einem spezifischen Zeitpunkt während der Vernetzungsreaktion vorliegen. Beispielsweise kann der Klebefilm in dem unvernetzten oder teilweisen Zustand als ein Haftklebefilm vorliegen und permanent haftklebrig sein, alternativ könnte der Klebefilm in dem unvernetzten oder teilweisen Zustand als ein Schmelzklebstoff ausgebildet sein und erst durch ein Anschmelzen haftklebrig werden. In dem vernetzten Zustand bilden die Polymere ein Polymer-Netzwerk aus. Die Vernetzung der Polymere unterscheidet sich von einer Polymerisierung, in welcher Monomere zur Bildung der Polymere verknüpft werden. Der Vernetzer ist ein Molekül mit zumindest zwei funktionalen Gruppen, welche mit korrespondierenden funktionalen Gruppen der Polymere reagieren können und die Polymere im Anschluss an die Vernetzungsreaktion an diesen korrespondierenden funktionalen Gruppen miteinander verbindet. Der Vernetzer kann entweder homobifunktionell oder heterobifunktionell sein. Homobifunktionelle Vernetzer weisen mehrere identische funktionale Gruppen auf, während heterobifunktionelle Vernetzer voneinander verschiedene funktionale Gruppen aufweisen. Der Vernetzer kann beispielsweise funktionale Gruppen auf Basis von Aminen, Amiden, Thiolen, Hydroxylen, Carboxylaten, Aldehyden, organischen Phosphaten, Maleinimiden, NHS-Estern, Sulfhydrilen, Säuren, Alkoholen, Isocyanaten und Halogeniden aufweisen. "Auf Basis" soll in diesem Zusammenhang so verstanden werden soll, dass sämtliche Derivate, die diesen Stoffgruppen zugeordnet werden können und dem Fachmann als für die Klebstoffherstellung geeignet bekannt sind, umfasst sein sollen. Der Vernetzer könnte als ein aktivierter Vernetzer ausgebildet sein und die Vernetzungsreaktion bei Kontakt mit den Polymeren sofort initiieren. Alternativ könnte der Vernetzer als ein deaktivierter Vernetzer ausgebildet sein und beispielsweise in Form eines Granulats oder Pulvers vorliegen, welches bei einer vordefinierten Temperatur schmilzt und den Vernetzer freigibt.

Darunter, dass der Klebefilm mittels der Klebefilm-Vorratsrolle bereitgestellt wird, soll verstanden werden, dass der Klebefilm Teil einer Klebefilm-Bahn ist, welche auf einen Kern der Klebefilm-Vorratsrolle aufgewickelt ist. Bevorzugt weist die Klebefilm-Bahn eine Vielzahl von Klebefilmen auf. Die Klebefilm-Bahn kann einen entfernbaren Träger aufweisen, der in einem nicht-applizierten Zustand eine äußere Oberfläche der Klebefilme abdeckt. Bevorzugt weist die Klebefilm-Bahn eine Matrixschicht auf, welche Aussparungen aufweist, in denen jeweils einer der Klebefilme angeordnet ist. In dem Fall, dass die Klebefilm-Bahn den entfernbaren Träger und die Matrixschicht aufweist, wird zwischen dem Abwickeln des Klebefilms und dem Applizieren auf dem Substrat die Matrixschicht entfernt und auf eine Entsorgungsrolle aufgewickelt und der entfernbare Träger nach dem Applizieren auf dem Substrat entfernt und auf eine weitere Entsorgungsrolle aufgewickelt. Der Prozess des Entfernens der Matrixschicht wird auch als "Entgittern" bezeichnet. Die Klebefilm-Vorratsrolle kann entweder durch ein Voranschreiten der Produktionslinie abgewickelt werden oder in ein bekanntes Pick-and-Place-Gerät integriert sein, in welchem ein Roboter die Klebefilme von der Klebefilm-Vorratsrolle entnimmt und auf dem Substrat appliziert. Das Integrieren des Klebefilms in bekannte Pick-and-Place-Geräte hat den Vorteil, dass bereits bestehende Produktionsanlagen für die Herstellung des elektronischen Systems nicht ersetzt, sondern lediglich an den neuen Applikationsprozess angepasst werden müssen.

Die elektronischen Komponenten weisen jeweils zumindest einen Kontakt auf, welcher über der Leiterbahn angeordnet und durch den Klebefilm elektrisch mit der Leiterbahn verbunden ist. Bevorzugt weisen die elektronischen Komponenten jeweils zumindest ein paar von Kontakten auf, welche zur Energieversorgung der jeweiligen elektronischen Komponente mit einem Paar von Leiterbahnen elektrisch verbunden sind. Die Kontaktfläche ist als eine Oberfläche des Kontakts zu verstehen, welche dem Klebefilm zugewandt ist. Die elektronischen Komponenten können jeweils beliebige Arten von Kontakten aufweisen, beispielsweise können die elektronischen Komponenten jeweils zumindest einen seitlichen Anschluss, wie sie beispielsweise bei SOD- und SOT-Bauteilen vorliegen, gegenüberliegende Kontaktflächen, wie sie bei Vielschichtkondensatoren vorliegen, oder hervorstehende Kugelkontakte, auch "ball grid array" genannt, aufweisen. Der Kontakt kann über ein Gehäuse der jeweiligen elektronischen Komponente hinausstehen. Bevorzugt sind die Kontakte mit dem Gehäuse der elektronischen Komponenten bündig.

Das elektronische System könnte weitere Elemente und Bauteile aufweisen, welche standardmäßig in elektronischen Systemen Einsatz finden, wie beispielsweise Einkapselungselemente, welche zu einem Schutz der elektronischen Komponenten vor Feuchtigkeit dienen. Das elektronische System könnte Klebemittel aufweisen, welche nicht zur Fixierung der elektronischen Komponenten vorgesehen sind, sondern beispielsweise eine elektrische Isolierung des elektronischen Systems bereitstellen, das elektronische System an einem mit dem elektronischen System auszustattenden Objekt fixieren oder die Einkapselungselemente an dem Substrat fixieren. Die Klebemittel könnten als Flüssigklebstoffe oder weitere Klebefilme ausgebildet sein. Ferner könnte das elektronische System auch Lötzinn und/oder Lötpasten aufweisen, welche beispielsweise Steckelemente an dem Substrat fixieren und mit der Leiterbahn kontaktieren könnten. Der Klebefilm kann sich über die bestückte Oberfläche des Substrats hinaus erstrecken. Beispielsweise kann ein überstehender Bereich des Klebefilms genutzt werden, um Einkapselungselemente an dem Substrat zu fixieren oder zur Einkapselung der elektronischen Komponenten umgeklappt werden.

In einer weiteren Ausgestaltung der Erfindung ist das Substrat als eine flexible Leiterplatte ausgebildet und das elektronische System reversibel verformbar. Bevorzugt sind die elektronischen Komponenten als flexible elektronische Komponenten, besonders bevorzugt beschichtete Bauteile, ausgebildet. Unter einem "beschichteten Bauteil" soll in diesem Zusammenhang ein Bauteil verstanden werden, welche zumindest ein Substrat und zumindest eine Beschichtung aufweist, wobei die Beschichtung durch ein schichtförmiges Aufbringen eines elektronischen Funktionsmaterials, welches vor der Beschichtung in flüssiger oder pastöser Form vorliegt, auf das Substrat hergestellt ist. Das beschichtete Bauteil kann eine beliebige Anzahl von auf das Substrat beschichteten Komponenten aufweisen. Das beschichtete Bauteil kann mittels beliebiger Beschichtungsverfahren oder Druckverfahren auf die Oberfläche des Substrats aufgetragen sein, wie beispielsweise Rakelbeschichtung, Schlitzdüsenbeschichtung, Vorhangbeschichtung, Tiefdruck, Offsetdruck, Flexodruck, Tintenstrahldruck, Siebdruck, LAM-Druck oder Stereolithographie Hierdurch kann ein flexibles elektronisches System bereitgestellt werden, welches in der Lage ist, sich unebenen Oberflächen anzupassen und somit eine hohe Anzahl an möglichen Anwendungsbereichen ermöglicht.

In einer weiteren Ausgestaltung der Erfindung sind die elektronischen Komponenten als oberflächenmontierte Bauelemente, oder auch "surface-mounted device" (SMD), ausgebildet. Unter einem "oberflächenmontierten Bauelement" soll in diesem Zusammenhang ein Bauelement verstanden werden, welches im Gegensatz zu THT-Bauelementen und THD-Bauelementen frei von Drahtanschlüssen oder anderweitigen Verbindungselementen und ausschließlich über Kontakte mit der Leiterbahn kontaktiert ist. Beschichtete Bauteile zählen zu den oberflächenmontierten Bauelementen. Besonders bevorzugt weisen die elektronischen Komponenten Maße auf, welche dem JEDEC-Standard für oberflächenmontierte Bauelemente entsprechen. Die elektronischen Komponenten können als aktive Bauteile oder passive Bauteile ausgebildet sein. Beispielsweise könnten die elektronischen Komponenten als Schalter, Relais, Resonatoren, Oszillatoren, Filter, Sensoren wie beispielsweise Drucksensoren, Lichtsensoren, Temperatursensoren, Feuchtigkeitssensoren oder Widerstandssensoren, Dosierpumpen, mikrofluidische Systeme, Widerstände, Kondensatoren, Spulen, Transformatoren, Magnete, Strahlungsquellen, Energiequellen wie beispielsweise Brennstoffzellen und/oder Solarzellen, Peltier-Elemente, Dioden, Gleichrichter, Transistoren, Piezo-Elemente, Datenspeicherelemente, Prozessoren, Chipsätze, Halbleiter, Lichtwellenleiter, Elektromotoren, Audio-Elemente wie beispielsweise Lautsprecher, Displayelemente wie beispielsweise LCD-Bauteile, Verbindungsbauteile wie beispielsweise ein Flachbandkabel und/oder Energiespeicher wie beispielsweise Batterien ausgebildet sein.

In einem weiteren Ausgestaltungbeispiel der Erfindung weisen die elektronischen Komponenten bei der Draufsicht auf das elektronische System eine Konturfläche auf, deren Flächeninhalt höchstens 25 mm² beträgt. Die Konturfläche der elektronischen Komponenten umfasst sämtliche funktionalen Bestandteile der elektronischen Komponenten. Unter "funktionalen Bestandteilen" sollen beispielsweise Gehäuse, Drähte, Kontakte und Leitungen verstanden werden, aber keine überstehenden Substrate. Bei elektronischen Komponenten, welche auf ein gemeinsames Substrat beschichtet und über Leiterbahnen verbunden sind, bilden das Substrat und die Leiterbahnen keine Teile der Konturfläche. Beispielsweise könnten die elektronischen Komponenten als Mini-LEDs oder Micro-LEDs ausgebildet sein. Bisher wurden elektronische Komponenten dieser Größe nur mit Flüssigklebstoffen verbunden, da die Scherkräfte, die auf den Klebstoff wirken, höher sind, je kleiner die Klebefläche ist. Es wurde aber überraschend festgestellt, dass durch das Andrücken der elektronischen Komponenten, während der Klebefilm haftklebrig ist, kombiniert mit der robusten Fixierung nach der Vernetzung des Klebefilms, ebenfalls diese Scherkräfte kompensiert werden können.

In einem nicht erfindungsgemäßen Ausgestaltungsbeispiel der Erfindung ist der Vernetzer als ein strahlungsaktivierbarer Vernetzer ausgebildet und der Klebefilm weist 0,1 bis 20 Gew.-%, bevorzugt 1 bis 10 Gew.-% und besonders bevorzugt 2 bis 7 Gew.-% des Vernetzers und 10 bis 90 Gew.-%, bevorzugt 20 bis 80 Gew.-% und besonders bevorzugt 30 bis 70 Gew.-% zumindest eines Harzes auf. Der Vernetzer kann als ein Radikalstarter ausgebildet sein. Beispielsweise könnte der Vernetzer ein Dibenzoylperoxid, Peroxodisulfat, Bis(2-ethylhexyl)peroxydicarbonat oder Methylethylketonperoxid aufweisen. Bevorzugt ist der Vernetzer als ein kationischer oder anionischer Initiator ausgebildet. Beispielsweise könnte der Vernetzer ein Lithiumorganyl, eine Grignard-Verbindun, eine Lewis-Säure, eine Brönstedt-Säure, ein Onium-Salz, ein Ferroceniumsalz, ein Thioxantheniumsalz, ein Pyridiniumsalz, ein Pyryliumsalz und/oder ein Thiapyriliumsalz aufweisen. Das Harz kann beispielsweise als ein Phenolharz, Epoxidharz, Polyacrylatharz oder Polyamidharz ausgebildet sein. Bevorzugt ist das Harz als eine Kombination eines aromatischen Epoxidharzes und eines cycloaliphatischen Epoxidharzes ausgebildet. Ferner kann der Klebefilm 1 bis 40 Gew.-%, bevorzugt 10 bis 30 Gew.-% zumindest eines Filmbildners aufweisen. Hierdurch kann ein Klebefilm bereitgestellt werden, welcher durch das Harz im unvernetzten Zustand haftklebrig ist und nach einer Bestrahlung seine Haftklebrigkeit verliert und eine starke mechanische Fixierung der elektronischen Komponenten ermöglicht.

Der Vernetzer ist als ein hitzeaktivierbarer Vernetzer ausgebildet und der Klebefilm weist 0,1 bis 20 Gew.-%, bevorzugt 5 bis 18 Gew.-% und besonders bevorzugt 8 bis 15 Gew.-% des Vernetzers und 40 bis 98 Gew.-%, bevorzugt 45 bis 90 Gew.-% und besonders bevorzugt 50 bis 70 Gew.-% eines thermoplastischen Polymers auf, wobei eine Aktivierungstemperatur des Vernetzers mindestens 10°C höher als eine Schmelztemperatur des thermoplastischen Polymers ist. Der Vernetzer kann als ein Radikalstarter ausgebildet sein. Beispielsweise könnte der Vernetzer ein Dibenzoylperoxid, Peroxodisulfat, Bis(2-ethylhexyl)peroxydicarbonat oder Methylethylketonperoxid aufweisen. Bevorzugt weist der Vernetzer zumindest ein mehrwertiges Isocyanat und/oder zumindest einen mehrwertigen Alkohol auf. Das thermoplastische Polymer ist als ein Polyurethan ausgebildet. Das thermoplastische Polymer ist entweder als ein kristallines Polymer ausgebildet und frei von amorphen Bereichen oder als ein teilkristallines Polymer ausgebildet, welches kristalline und amorphe Bereiche aufweist. Hierdurch kann ein Klebefilm bereitgestellt werden, welcher in dem unvernetzten Zustand, welcher bei einer Temperatur zwischen der Schmelztemperatur und der Aktivierungstemperatur vorliegt, haftklebrig ist und nach einer Erwärmung über die Aktivierungstemperatur seine Haftklebrigkeit verliert und eine starke mechanische Fixierung der elektronischen Komponenten ermöglicht.

In einem nicht erfindungsgemäßen Ausgestaltungsbeispiel der Erfindung weist der Klebefilm 0,1 bis 20 Gew.-%, bevorzugt 10 bis 20 Gew.-% eines ersten Vernetzers und 0,1 bis 20 Gew.-%, bevorzugt 0,5 bis 10 Gew.-% und besonders bevorzugt 1 bis 5 Gew.-% eines zweiten Vernetzers auf, wobei der erste Vernetzer und der zweite Vernetzer hitzeaktivierbare Vernetzer mit unterschiedlichen Aktivierungstemperaturen, strahlungsaktivierbare Vernetzer mit unterschiedlichen Absorptionsspektren, oder eine Kombination eines hitzeaktivierbareren und eines strahlungsaktivierbaren Vernetzers sind, wobei der Klebefilm nach einer ersten Vernetzung durch den ersten Vernetzer haftklebrig ist und diese Haftklebrigkeit nach einer zweiten Vernetzung durch den zweiten Vernetzer verliert. Der erste Vernetzer und der zweite Vernetzer können beispielsweise als Radikalstarter, kationische Initiatoren oder anionische Initiatoren ausgebildet sein. Bevorzugt sind der erste Vernetzer und der zweite Vernetzer als hitzeaktivierbare Vernetzer ausgebildet, wobei der erste Vernetzer eine Aktivierungstemperatur von höchstens 25°C, bevorzugt höchstens 10°C und besonders bevorzugt höchstens 5°C aufweist und der zweite Vernetzer eine Aktivierungstemperatur von mindestens 35°C, bevorzugt mindestens 50°C und besonders bevorzugt mindestens 60°C aufweist. Der erste Vernetzer kann als ein Amin-Vernetzer wie beispielsweise aliphatische Amine, aliphatische Polyamine oder Phenalkamine oder als ein Amid-Vernetzer wie beispielsweise Phenalkamine und der zweite Vernetzer als ein Amid-Vernetzer wie beispielsweise Dicyandiamide ausgebildet sein. Hierdurch kann ein Klebefilm bereitgestellt werden, welcher in einem unvernetzten Zustand nicht haftklebrig sein kann, aber nach der ersten Vernetzung in einem teilvernetzten Zustand vorliegt und haftklebrig ist und nach der zweiten Vernetzung diese Haftklebrigkeit verliert und eine starke mechanische Fixierung der elektronischen Komponenten ermöglicht.

In einer weiteren Ausgestaltung der Erfindung weist der Klebefilm eine Dicke von 1 bis1000 µm, bevorzugt 5 bis 500 µm und besonders bevorzugt 5 bis 100 µm, elektrisch leitfähige Partikel mit einem durchschnittlichen Durchmesser von 1 bis 350 µm, bevorzugt 5 bis 200µm sowie einen Pitch von 2 bis 1000 µm, bevorzugt 5 bis 500 µm und besonders bevorzugt 5 bis 100 µm auf. Der jeweilige Pitch ist abhängig von einem Verhältnis der Schichtdicke des Klebefilms zur Größe und Dichte der elektrisch leitfähigen Partikel. Hierdurch kann der Pitch an die jeweiligen elektronischen Komponenten angepasst werden. Beispielsweise könnten verschiedene Klebefilme bereitgestellt werden, welche jeweils für oberflächenmontierte Bauelemente verschiedener Größen gemäß dem JEDEC-Standard ausgelegt sind.

Das elektronische System weist eine Vielzahl von elektronischen Komponenten auf, welche voneinander beabstandet auf dem Klebefilm aufliegen. Die Vielzahl der elektronischen Komponenten kann eine beliebige Anzahl elektronischer Komponenten umfassen, bevorzugt umfasst die Vielzahl der elektronischen Komponenten mindestens 5, besonders bevorzugt mindestens 10 elektronische Komponenten. Die elektronischen Komponenten können zueinander identisch oder voneinander verschieden sein. Hierdurch kann die Flexibilität und Skalierbarkeit des elektronischen Systems voll ausgenutzt werden.

Die elektronischen Komponenten können beliebige Anteile der Oberfläche des Substrats bedecken. In einer weiteren Ausgestaltung der Erfindung macht die bestückte Oberfläche des Substrats mindestens 40 %, bevorzugt mindestens 60 %, besonders bevorzugt mindestens 80 % der Oberfläche des Substrats aus. Beispielsweise könnte das elektronische System als ein Anzeigeelement und die elektronischen Komponenten als LEDs, Mini-LEDs oder Micro-LEDs ausgebildet sein. Hierdurch können die Vorteile des erfindungsgemäßen elektronischen Systems sowie des erfindungsgemäßen Verfahrens voll ausgenutzt werden, indem nahezu die gesamte Oberfläche mit dem Klebefilm abgedeckt und eine große Anzahl an elektronischen Komponenten durch den Klebefilm fixiert und kontaktiert werden.

Die Anordnung der elektronischen Komponenten auf dem Substrat kann beliebig sein. In einer weiteren Ausgestaltung der Erfindung sind die elektronischen Komponenten in Form eines Musters angeordnet, in welchem benachbarte elektronische Komponenten identische Abstände zueinander aufweisen. Bevorzugt sind die elektronischen Komponenten in Form eines Musters angeordnet, in welchem die elektronischen Komponenten in der Draufsicht gemeinsam eine geometrische Form, beispielsweise ein Viereck, Dreieck oder Oval, ausbilden. Besonders bevorzugt sind die elektronischen Komponenten in Form einer Matrix angeordnet. Hierdurch kann der Klebefilm auf eine einfache und effiziente Weise auf die jeweiligen elektronischen Komponenten zugeschnitten werden.

In dem Verfahren zur industriellen Herstellung des elektronischen Systems könnte die elektronische Komponente mittels eines Roboters auf den applizierten Klebefilm aufgebracht werden. In einer weiteren Ausgestaltung der Erfindung ist die elektronische Komponente bereits vor der Applizierung des Klebefilms auf dem Klebefilm angeordnet und wird mittels der Klebefilm-Vorratsrolle bereitgestellt. Bevorzugt weist die Klebefilm-Vorratsrolle die elektronischen Komponenten einer Mehrzahl von elektronischen Systemen auf, welche entlang einer Länge der Klebefilm-Bahn angeordnet sind. Im Fall, dass die Klebefilm-Bahn einen entfernbaren Träger aufweist, könnte der entfernbare Träger eine Mehrzahl von Taschen aufweisen, welche jeweils die elektronischen Komponenten eines der elektronischen Systeme aufnehmen. Die elektronische Komponente wird, während sich der Klebefilm in dem unvernetzten oder teilvernetzten Zustand befindet, auf dem Klebefilm befestigt, wobei der Klebefilm im Anschluss an die Applizierung in den vernetzten Zustand überführt wird und seine Haftklebrigkeit verliert. Hierdurch kann die Herstellung des elektronischen Systems völlig ohne den Einsatz von Robotern und Pick-and-Place Prozessen ermöglicht werden, wodurch eine Herstellungsdauer und eine Komplexität einer Anlage zur Durchführung des Herstellungsverfahrens nicht länger von einer Anzahl der zu befestigenden elektronischen Komponenten abhängt. Vorteilhaft kann eine Anlage, die das Verfahren ausführt, zur Herstellung verschiedener elektronischer Systeme lediglich mit der jeweils korrespondierenden Klebefilm-Vorratsrolle ausgerüstet werden, wodurch sich aufwändige Umbauten oder Umprogrammierungen vermeiden lassen.

Weitere Vorteile ergeben sich aus der folgenden Zeichnungsbeschreibung.

Es zeigen:
- Fig. 1: Eine schematische Darstellung eines erfindungsgemäßen elektronischen Systems in einer Draufsicht.
- Fig. 2: Ein schematisches Verlaufsdiagramm eines erfindungsgemäßen Verfahrens zur industriellen Herstellung des elektronischen Systems.
- Fig. 3: Eine schematische Darstellung einer Anlage zur Ausführung des Verfahrens.

Aus Gründen der Übersichtlichkeit wird mehreren zueinander identischen Objekten in den Figuren jeweils nur ein Bezugszeichen zugeordnet.

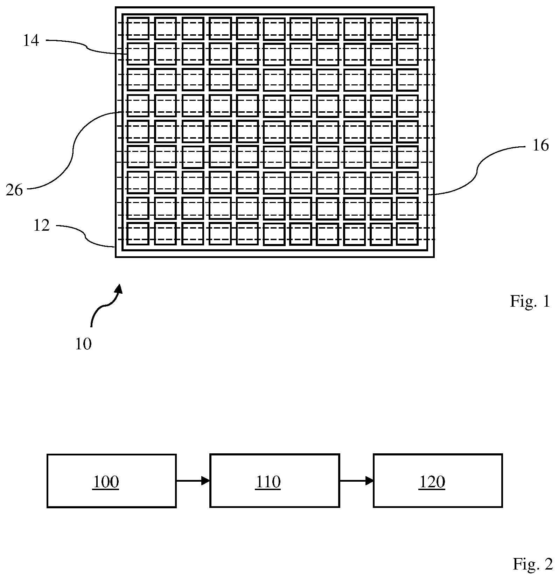

Figur 1 zeigt ein elektronisches System 10 in einer Draufsicht. Das elektronische System 10 ist als ein Anzeigeelement ausgebildet. Das elektronische System 10 weist ein Substrat 12 auf. Das Substrat 12 ist als eine flexible Leiterplatte ausgebildet. Alternativ könnte das Substrat 12 auch als eine starre Leiterplatte ausgebildet sein. Das Substrat 12 weist eine Vielzahl von auf einer Oberfläche des Substrats 12 angeordneten Leiterbahnen 26 auf. Die Leiterbahnen 26 sind als gedruckte Leiterbahnen ausgebildet.

Das elektronische System 10 weist einen anisotrop elektrisch leitfähigen Klebefilm 16 auf. Der Klebefilm 16 ist auf der Oberfläche des Substrats 12 angeordnet. Der Klebefilm 16 ist als ein Transferfilm ausgebildet. Alternativ könnte der Klebefilm 16 auch als Teil eines einseitigen oder doppelseitigen Klebebands ausgebildet sein. Der Klebefilm 16 befindet sich in einem applizierten Zustand, entsprechend wurde der entfernbare Träger (nicht dargestellt) des Transferklebebands bereits entfernt. Der Klebefilm 16 ist auf der Oberfläche des Substrats 12 aufgebracht.

Der Klebefilm 16 weist eine Dicke von 500 µm auf. Der Klebefilm 16 weist elektrisch leitfähige Partikel mit einem durchschnittlichen Durchmesser von etwa 175 µm auf. Der Klebefilm 16 weist einen Pitch von 500 µm auf.

Der Klebefilm 16 ist in einem unvernetzten oder teilvernetzten Zustand haftklebrig und in verliert in einem vernetzten Zustand seine Haftklebrigkeit.

Der Klebefilm 16 kann beispielsweise die folgende nicht erfindungsgemäße Zusammensetzung (Beispiel 1) aufweisen:

| Substanz | Menge [Gew.-%] |
|---|---|
| Filmbildner | 8,8 |
| Aromatisches Epoxidharz | 54,4 |
| Epoxidierte Polyetherverbindung | 9,6 |
| Polyethylenglykol | 5,6 |
| Kationischer Initiator (Oniumsalz) | 1,6 |
| Elektrisch leitfähige Partikel | 20 |

Alternativ kann der Klebefilm 16 die folgende Zusammensetzung (Beispiel 2) aufweisen:

| Substanz | Menge [Gew.-%] |
|---|---|
| Filmbildner | 1,4 |
| Kristallines Polyurethan | 54,5 |
| Radikalstarter (mehrwertiges Isocyanat) | 11,5 |
| Elektrisch leitfähige Partikel | 32,6 |

Das kristalline Polyurethan weist eine Schmelztemperatur von 50°C auf. Der Radikalstarter weist eine Aktivierungstemperatur von 100°C auf.

Alternativ kann der Klebefilm 16 die folgende nicht erfindungsgemäße Zusammensetzung (Beispiel 3) aufweisen:

| Substanz | Menge [Gew.-%] |
|---|---|
| Epoxidharz | 68,8 |
| Amin-Vernetzer | 4,5 |
| Amid-Vernetzer | 3,8 |
| Katalysator | 1,9 |
| Kieselsäure | 1 |
| Elektrisch leitfähige Partikel | 20 |

Der Amin-Vernetzer weist eine Aktivierungstemperatur von 5°C auf. Der Amid-Vernetzer weist eine Aktivierungstemperatur von 100°C auf.

Das elektronische System 10 weist eine Mehrzahl von elektronischen Komponenten 14 auf. Die elektronischen Komponenten 14 weisen jeweils zwei Kontakte (nicht dargestellt) mit jeweils einer Kontaktflächen auf. Die elektronischen Komponenten 14 liegen mit den Kontaktflächen auf dem Klebefilm 16 auf. Die elektronischen Komponenten 14 sind zueinander identisch ausgebildet. Alternativ könnten die elektronischen Komponenten 14 zueinander unterschiedlich ausgebildet sein. Die elektronischen Komponenten 14 sind als beschichtete Bauteile ausgebildet. Durch die Kombination einer flexiblen Leiterplatte und beschichteten Bauteilen ist das elektronische System 10 reversibel verformbar und lässt sich auch an unebene Oberflächen anpassen. Die elektronischen Komponenten 14 sind als beschichtete LEDs ausgebildet, welche in der Draufsicht jeweils eine Konturfläche aufweisen, deren Flächeninhalt etwa 1mm² beträgt. In diesem Beispiel weist jede beschichtete LED ein eigenes Substrat auf, alternativ könnten sämtliche LEDs auf ein gemeinsames Substrat beschichtet sein.

Die Kontakte der elektronischen Komponenten 14 stellen eine Energieversorgung der elektronischen Komponenten 14 bereit. Die Leiterbahnen 26 sind paarweise angeordnet, wobei jeweils ein Paar der Leiterbahnen 26 die Energieversorgung einer Reihe von elektronischen Komponenten 14 bereitstellt.

Eine bestückte Oberfläche des Substrats 12 macht etwa 90 % der Oberfläche des Substrats 12 aus. Die elektronischen Komponenten 14 sind in Form einer Matrix angeordnet.

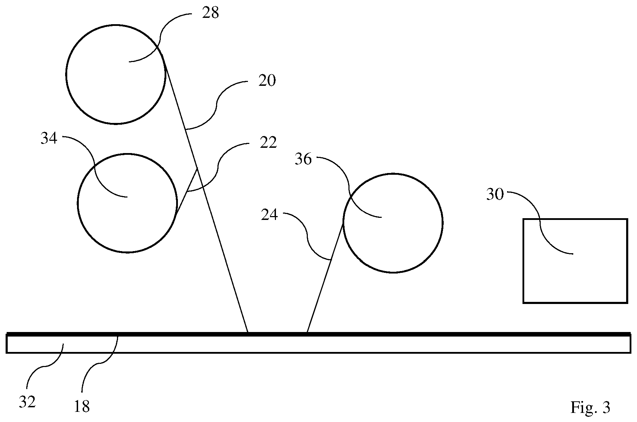

Figur 2 zeigt ein schematisches Verlaufsdiagramm eines Verfahrens zur industriellen Herstellung des elektronischen Systems 10. Figur 3 zeigt eine Anlage zur Ausführung des Verfahrens. In einem Transportschritt 100 wird eine Substrat-Bahn 18, welche eine Vielzahl von Substraten 12 aufweist, entlang einer Produktionslinie 32 transportiert. Die Substrat-Bahn 18 wird von einer Substrat-Vorratsrolle (nicht dargestellt) abgewickelt, alternativ könnten die Substrate 12 in sich gefaltet in einem Behälter eines Substratspenders (nicht dargestellt) vorliegen und aus einer Öffnung des Substratspenders herausgezogen werden.

Die elektronischen Komponenten 14 sind bereits vor einer Applizierung des Klebefilms 16 auf dem Klebefilm 16 angeordnet. Der Klebefilm 16 des Beispiels 1 befindet sich zu diesem Zeitpunkt in einem unvernetzten Zustand, in dem der Klebefilm 16 haftklebrig ist. Der Klebefilm 16 des Beispiels 2 wird bei der Anordnung der elektronischen Komponenten 16 auf dem Klebefilm 16 durch Erwärmung in den unvernetzten Zustand überführt und ist nach Abkühlung und Aufwicklung auf die Klebefilm-Vorratsrolle nicht mehr haftklebrig. Der Klebefilm 16 des Beispiels 3 befindet sich zu diesem Zeitpunkt in einem teilvernetzten Zustand, in dem der Klebefilm 16 haftklebrig ist.

Der Klebefilm 16 wird mittels einer Klebefilm-Vorratsrolle bereitgestellt. In einem Applizierschritt 110 wird eine Klebefilm-Bahn 20 von der Klebefilm-Vorratsrolle 28 abgewickelt. Die Klebefilm-Bahn 20 weist einen entfernbaren Träger 24 auf. Die Klebefilm-Bahn 20 weist eine Matrixschicht 22 auf. Die Klebefilm-Bahn 20 weist eine Vielzahl an Klebefilmen 16 auf, welche in Aussparungen der Matrixschicht 22 angeordnet sind. Die Matrixschicht wird entgittert und auf eine Entsorgungsrolle 34 aufgewickelt. Anschließend wird zur Verbindung der elektronischen Komponenten 14 mit den Substraten 12 der entfernbare Träger 24 gemeinsam mit den Klebefilmen 16 auf die Substrat-Bahn 18 appliziert. Schließlich wird der entfernbare Träger 24 entfernt und auf eine weitere Entsorgungsrolle 36 aufgewickelt, sodass auf der Produktionslinie 32 nur die Substrat-Bahn 18, die applizierten Klebefilme 16 und die auf den Klebefilmen 16 angeordneten elektronischen Komponenten 14 verbleiben. Das Abwickeln und Applizieren der Klebefilm-Bahn 20 ist ein kontinuierlicher Prozess, welcher allein durch das Fortschreiten der Produktionslinie 32 angetrieben wird. Beispielsweise könnte die Klebefilm-Bahn 20 Randbereiche aufweisen, in welche in regelmäßigen Abständen Löcher gestanzt sind, in welche Pins der Produktionslinie 32 eingreifen. Alternativ könnten die fertigen elektronischen Systeme 10 am Ende der Produktionslinie 32 auf eine Produktrolle (nicht dargestellt) aufgewickelt werden und das Abwickeln und Applizieren der Klebefilm-Bahn 20 durch ein Rotieren der Produktrolle angetrieben werden. Nach dem Applizierschritt 110 werden die Substrat-Bahn 18, die Klebefilme 16 und die elektronischen Komponenten 14 zu einem Stempel 30 geführt.

In einem Vernetzungsschritt 120 werden die Klebefilme 16 mittels eines Stempels 30 in den vernetzten Zustand überführt und verlieren dadurch ihre Haftklebrigkeit. Der Stempel 30 weist Ausnehmungen (nicht dargestellt) auf, deren Form an eine Erstreckung der elektronischen Komponenten 14 angepasst sind und sie damit sowohl andrücken als auch fixieren kann. Alternativ könnte der Stempel 30 auch aus einem weichen, elastischen Material bestehen, welches sich an die elektronischen Komponenten 14 anschmiegt und ebenfalls ein Andrücken und Fixieren der elektronischen Komponenten 14 erlaubt. Für den Klebefilm 16 des Beispiels 1 weist der Stempel 30 zusätzlich eine Strahlungseinheit (nicht dargestellt) auf, welche den Klebefilm 16 bei einem Andrücken des Stempels 30 bestrahlt. Für die Klebefilme 16 der Beispiele 2 oder 3 ist der Stempel 30 als ein aus dem Stand der Technik bekannter Heizstempel ausgebildet.

Der Vernetzungsschritt 120 könnte alternativ auch mit einem Klemm-Mechanismus (nicht dargestellt) durchgeführt werden, um die elektronischen Komponenten 14 an die Klebefilme 16 anzudrücken, wobei die Substrate 12 gemeinsam mit dem Klemm-Mechanismus durch eine Strahlungsquelle (nicht dargestellt) bei Klebefilmen 16 des Beispiels 1 oder einen Reflow-Ofen (nicht dargestellt) bei Klebefilmen 16 der Beispiele 2 oder 3 geführt wird, in welchem die Klebefilme 16 auf 100°C erwärmt werden. Eine Reaktionsdauer der Überführung der Klebefilme 16 in den vernetzten Zustand beträgt etwa 10 Sekunden. Alternativ könnte die Reaktionsdauer abhängig von der verwendeten Zusammensetzung auch bis zu 5 Minuten betragen.

Im Anschluss an den Vernetzungsschritt 120 befinden sich die Klebefilme 16 in dem vernetzten Zustand und sind nicht mehr haftklebrig. Die elektronischen Komponenten 14 sind fest mit den Substraten 12 verbunden und bilden fertige elektronische Systeme 10 aus. Die Verfahrensschritte 100, 110 und 120 verlaufen kontinuierlich und gleichzeitig.

Im Anschluss an den Vernetzungsschritt 120 könnten die elektronischen Systeme 10 sofort voneinander getrennt werden, entweder durch ein Stanzen oder Schneiden an Rändern von benachbarten Substraten 12. Alternativ könnten die elektronischen Systeme 10 zunächst auf eine Produktrolle (nicht dargestellt) aufgewickelt werden, um erst später bei einer Anwendung getrennt zu werden.

### Bezugszeichen

- 10: Elektronisches System
- 12: Substrat
- 14: Elektronische Komponente
- 16: Klebefilm
- 18: Substrat-Bahn
- 20: Klebefilm-Bahn
- 22: Matrixschicht
- 24: Entfernbarer Träger
- 26: Leiterbahn
- 28: Klebefilm-Vorratsrolle
- 30: Stempel
- 32: Produktionslinie
- 34: Entsorgungsrolle
- 36: Weitere Entsorgungsrolle
- 100: Transportschritt
- 110: Applizierschritt
- 120: Heizschritt

## Patentansprüche

1. Elektronisches System (10), aufweisend:
ein Substrat (12), welches auf zumindest einer Oberfläche zumindest eine Leiterbahn (26) aufweist,
einen anisotrop elektrisch leitfähigen Klebefilm (16), welcher auf der Oberfläche des Substrats (12) angeordnet ist und
eine Vielzahl von elektronischen Komponenten (14), welche jeweils zumindest eine Kontaktfläche aufweisen und mit der Kontaktfläche voneinander beabstandet auf dem Klebefilm (16) aufliegen,
wobei der Klebefilm senkrecht zu einer Hauptseite des Klebefilms elektrisch leitfähig und parallel zu der Hauptseite zumindest in einem Maße elektrisch isolierend ist, dass ein Abstand benachbarter Kontaktflächen parallel zu der Hauptseite des Klebefilms groß genug ist, um einen Kurzschluss zu vermeiden, wobei der Klebefilm (16) einen Vernetzer aufweist, wobei
der Vernetzer als ein hitzeaktivierbarer Vernetzer ausgebildet ist, dadurch charakterisiert, dass der Klebefilm (16) 0,1 bis 20 Gew.-% des Vernetzers und 40 bis 98 Gew.-% eines thermoplastischen Polymers aufweist, welches als kristallines oder teil-kristallines Polyurethan ausgebildet ist, wobei eine Aktivierungstemperatur des Vernetzers mindestens 10°C höher als eine Schmelztemperatur des thermoplastischen Polymers ist,
wobei der Klebefilm in einem unvernetzten Zustand, welcher bei einer Temperatur zwischen der Schmelztemperatur und der Aktivierungstemperatur vorliegt, haftklebrig ist und nach einer Erwärmung über die Aktivierungstemperatur seine Haftklebrigkeit verliert und eine starke mechanische Fixierung der elektronischen Komponenten ermöglicht.

2. Elektronisches System (10) nach Anspruch 1, wobei das Substrat (12) als eine flexible Leiterplatte ausgebildet und das elektronische System (10) reversibel verformbar ist.

3. Elektronisches System (10) nach einem der vorhergehenden Ansprüche, wobei die elektronischen Komponenten bei einer Draufsicht auf das elektronische System (10) jeweils eine Konturfläche aufweisen, deren Flächeninhalt höchstens 25 mm² beträgt.

4. Elektronisches System (10) nach einem der vorhergehenden Ansprüche, wobei der Klebefilm (16) eine Schichtdicke von 1 bis 1000 µm, elektrisch leitfähige Partikel mit einem durchschnittlichen Durchmesser von 1 bis 350 µm sowie einen Pitch von 2 bis 1000 µm aufweist.

5. Elektronisches System (10) nach einem der vorhergehenden Ansprüche, wobei eine bestückte Oberfläche des Substrats mindestens 40 % der Oberfläche des Substrats (12) ausmacht.

6. Elektronisches System (10) nach einem der vorhergehenden Ansprüche, wobei die elektronischen Komponenten (14) in Form eines Musters angeordnet sind, in welchem benachbarte elektronische Komponenten (14) identische Abstände zueinander aufweisen.

7. Verfahren zur industriellen Herstellung des elektronischen Systems (10) nach einem der vorhergehenden Ansprüche, wobei der Klebefilm (16) als ein Transferfilm ausgebildet ist und mittels einer Klebefilm-Vorratsrolle bereitgestellt wird, das Substrat (12) entlang einer Produktionslinie transportiert wird, und der Klebefilm (16) kontinuierlich abgewickelt und zur Verbindung der elektronischen Komponenten (14) mit dem Substrat (12) auf dem Substrat (12) appliziert wird.

8. Verfahren gemäß Anspruch 7, wobei die elektronischen Komponenten (14) bereits vor der Applizierung des Klebefilms (16) auf dem Klebefilm (16) angeordnet sind und mittels der Klebefilm-Vorratsrolle bereitgestellt werden.

## Claims

1. Electronic system (10), comprising:
a substrate (12) comprising at least one conductive trace (26) on at least one surface,
an anisotropic electrically conductive adhesive film (16) arranged on the surface of the substrate (12), and
a multitude of electronic components (14), each comprising at least one contact surface and which are arranged spaced apart from each other on the adhesive film (16) via their contact surfaces,
wherein the adhesive film is electrically conductive perpendicular to a main side of the adhesive film, and electrically insulating parallel to the main side, so that a distance of neighboring contact surfaces is big enough to prevent short circuits, wherein the adhesive film (16) comprises a curing agent, wherein
the curing agent is a heat-activatable curing agent, **characterized in that** the adhesive film (16) comprises 0,1 to 20 wt.-% of the curing agent and 40 to 98 wt.-% of a thermoplastic polymer, which is crystalline or semi-crystalline polyurethane, wherein an activation temperature of the curing agent is at least 10°C higher than a melting temperature of the thermoplastic polymer,
wherein the adhesive film is tacky in a non-cured state at a temperature between the melting temperature and the activation temperature and, after a heating above the activation temperature, loses its tackiness and allows for a strong mechanical fixation of the electronic components.

2. Electronic system (10) according to claim 1, wherein the substrate (12) is a flexible circuit board and the electronic system (10) is reversibly deformable.

3. Electronic system (10) according to any of the preceding claims, wherein the electronic components, in a top view onto the electronic system (10), each comprise a contour area with an area of at most 25 mm².

4. Electronic system (10) according to any of the preceding claims, wherein the adhesive film (16) comprises a layer thickness of 1 to 1000 µm, electrically conductive particles with an average diameter of 1 to 350 µm as well as a pitch of 2 to 1000 µm.

5. Electronic system (10) according to any of the preceding claims, wherein a populated surface of the substrate constitutes at least 40 % of the surface of the substrate (12).

6. Electronic system (10) according to any of the preceding claims, wherein the electronic components (14) are arranged in form of a pattern in which neighboring electronic components (14) are spaced apart equally to each other.

7. Method for industrial manufacture of the electronic system (10) according to any of the preceding claims, wherein the adhesive film (16) is a transfer film which is provided via an adhesive film supply roll, the substrate (12) is transported along a production line, and the adhesive film (16) is continuously unwound and applied onto the substrate (12) for adhering the electronic components (14) to the substrate (12).

8. Method according to claim 7, wherein the electronic components (14) are arranged on the adhesive film (16) before the application of the adhesive film (16) and are supplied via the adhesive film supply roll.

## Revendications

1. Système électronique (10), comprenant :
un substrat (12) comprenant au moins une piste conductrice (26) sur au moins une surface,
un film adhésif électriquement conducteur anisotrope (16) disposé sur la surface du substrat (12), et
une multitude de composants électroniques (14), comprenant chacun au moins une surface de contact et disposés à distance les uns des autres sur le film adhésif (16) par l'intermédiaire de leurs surfaces de contact,
dans lequel le film adhésif est électriquement conducteur perpendiculairement à une face principale du film adhésif, et électriquement isolant parallèlement à la face principale, de sorte que la distance entre des surfaces de contact voisines soit suffisante pour empêcher les courts-circuits,
dans lequel le film adhésif (16) comprend un agent de réticulation, dans lequel l'agent de réticulation est un agent de réticulation activable par la chaleur,
**caractérisé en ce que** le film adhésif (16) comprend de 0,1 à 20 % en poids de l'agent de réticulation et de 40 à 98 % en poids d'un polymère thermoplastique, qui est un polyuréthane cristallin ou semi-cristallin, dans lequel une température d'activation de l'agent de réticulation est supérieure d'au moins 10 °C à une température de fusion du polymère thermoplastique,
dans lequel le film adhésif est poisseux à l'état non réticulé à une température comprise entre la température de fusion et la température d'activation et, après un chauffage au-dessus de la température d'activation, perd son caractère poisseux et permet une fixation mécanique solide des composants électroniques.

2. Système électronique (10) selon la revendication 1, **caractérisé en ce que** le substrat (12) est une carte de circuit imprimé flexible et que le système électronique (10) est déformable de manière réversible.

3. Système électronique (10) selon l'une quelconque des revendications précédentes, **caractérisé en ce que** les composants électroniques, vus de dessus du système électronique (10), comprennent chacun une zone de contour d'une surface maximale de 25 mm².

4. Système électronique (10) selon l'une quelconque des revendications précédentes, dans lequel le film adhésif (16) comprend une couche d'une épaisseur de 1 à 1 000 µm, des particules conductrices d'un diamètre moyen de 1 à 350 µm et un pas de 2 à 1 000 µm.

5. Système électronique (10) selon l'une quelconque des revendications précédentes, dans lequel la surface du substrat occupée représente au moins 40 % de la surface totale du substrat (12).

6. Système électronique (10) selon l'une quelconque des revendications précédentes, dans lequel les composants électroniques (14) sont agencés selon une configuration où les composants électroniques (14) voisins sont équidistants.

7. Procédé de fabrication industrielle du système électronique (10) selon l'une quelconque des revendications précédentes, dans lequel le film adhésif (16) est un film de transfert fourni par un rouleau d'alimentation de film adhésif, le substrat (12) est transporté le long d'une ligne de production, et le film adhésif (16) est déroulé et appliqué en continu sur le substrat (12) pour y coller les composants électroniques (14).

8. Procédé selon la revendication 7, dans lequel les composants électroniques (14) sont disposés sur le film adhésif (16) avant l'application de ce dernier et sont fournis par le rouleau d'alimentation de film adhésif.
